Europäisches Patentamt

European Patent Office

Office européen des brevets

(19)

(11) Veröffentlichungsnummer : **0 106 000**
**B1**

(12) # EUROPÄISCHE PATENTSCHRIFT

(45) Veröffentlichungstag der Patentschrift :
21.01.87

(21) Anmeldenummer : 82710049.6

(22) Anmeldetag : 09.10.82

(51) Int. Cl.⁴ : **H 04 N 5/213**, H 04 N 9/64,
H 03 H 17/06

(54) Digitalschaltung zur Unterdrückung von Änderungen eines Digitalsignals.

(43) Veröffentlichungstag der Anmeldung :
25.04.84 Patentblatt 84/17

(45) Bekanntmachung des Hinweises auf die Patenterteilung : 21.01.87 Patentblatt 87/04

(84) Benannte Vertragsstaaten :
DE FR GB IT NL

(56) Entgegenhaltungen :
DE-A- 2 618 391
DE-A- 2 950 465
PROCEEDINGS OF THE I.E.E.-G, Band 127, Nr. 2, April
1980, Seiten 52-56, Stevenage, GB. T. J. DENNIS:
"Nonlinear temporal filter for television picture noise
reduction"

(73) Patentinhaber : Deutsche ITT Industries GmbH
Hans-Bunte-Strasse 19 Postfach 840
D-7800 Freiburg (DE)
DE
ITT INDUSTRIES INC.
320 Park Avenue
New York, NY 10022 (US)
FR GB IT NL

(72) Erfinder : Flamm, Peter Michael
Stephan-Meier-Strasse 167
D-7800 Freiburg i.Br. (DE)

(74) Vertreter : Morstadt, Volker, Dipl.-Ing. et al
c/o Deutsche ITT Industries GmbH Patent/Lizenzab-
teilung Postfach 840 Hans-Bunte-Strasse 19
D-7800 Freiburg/Brsg. (DE)

Anmerkung : Innerhalb von neun Monaten nach der Bekanntmachung des Hinweises auf die Erteilung des
europäischen Patents im Europäischen Patentblatt kann jedermann beim Europäischen Patentamt gegen das erteilte
europäische Patent Einspruch einlegen. Der Einspruch ist schriftlich einzureichen und zu begründen. Er gilt erst als
eingelegt, wenn die Einspruchsgebühr entrichtet worden ist (Art. 99(1) Europäisches Patentübereinkommen).

## Beschreibung

Die Erfindung betrifft eine Digitalschaltung zur getakteten Unterdrückung von Digitalsignal-Änderungen, deren Vorzeichen umgekehrt zum Vorzeichen von Digitalsignal-Änderungen vorausgegangener Zeitpunkte eines Taktsignals ist, wobei die positiven Werte des Digitalsignals im natürlichen Dualcode und seine negativen Werte in der Zweierkomplement-Darstellung des natürlichen Dualcodes vorliegen, vgl. den Oberbegriff des Anspruchs 1.

Bei der Verarbeitung von derartigen Digitalsignalen, die beispielsweise mittels Analog-Digital-Wandlern aus Analogsignalen gebildet werden, sind die Störungen der Analogsignale, die beispielsweise auf deren Übertragungsweg oder bei deren analoger Signalverarbeitung ihnen überlagert werden, oft genauso nachteilig wie dies bei den Analogsignalen der Fall ist. Es besteht daher ein generelles Bedürfnis nach Digitalschaltungen, mit denen derartige Störsignale eliminiert werden können.

Die Aufgabe der in den Ansprüchen gekennzeichneten Erfindung besteht daher darin, eine Digitalschaltung anzugeben, mit der die erwähnten Störungen beseitigt werden können. Bei der Lösung dieser Aufgabe ist zu berücksichtigen, daß sich überlagerte Störungen des Digitalsignals bezüglich der Änderungen in den einzelnen Stellen des Digitalsignals genauso verhalten, wie Änderungen des idealen Digitalsignals. Die Lösung basiert auf der Erkenntnis des Erfinders, daß die Störsignale unterdrückbar sind, wenn solche Änderungen des Digitalsignals unterdrückt werden, deren Vorzeichen umgekehrt zu dem von Signaländerungen vorausgegangener Taktzeitpunkte des Taktsignals ist.

Aus der Zeitschrift « Proc. of the IEE, Part G », April 1980, Seiten 52 bis 56 ist ein rekursives Digitalfilter zur Rauschverminderung von PCM-Fernsehsignalen bekannt, das einen Subtrahierer, einen Addierer, einen Multiplizierer und einen Bildspeicher enthält. Die auch bei der Erfindung vorhandenen Subtrahierer bzw. Addierer sind jedoch anders in die verschiedenen Signalpfade eingefügt und haben daher eine andere Funktion.

Die Erfindung wird nun anhand der Figuren der Zeichnung näher erläutert.

Figur 1   zeigt in Form eines Blockschaltbilds ein Ausführungsbeispiel der Erfindung,

Figur 2   zeigt als Blockschaltbild eine Abwandlung der Anordnung nach Fig. 1 für die Unterdrückung von Änderungen in der niederstwertigen Stelle des Digitalsignals,

Figur 3   zeigt eine Weiterbildung der Anordnung nach Fig. 1, und

Figur 4   zeigt eine entsprechende Weiterbildung der Anordnung nach Fig. 2.

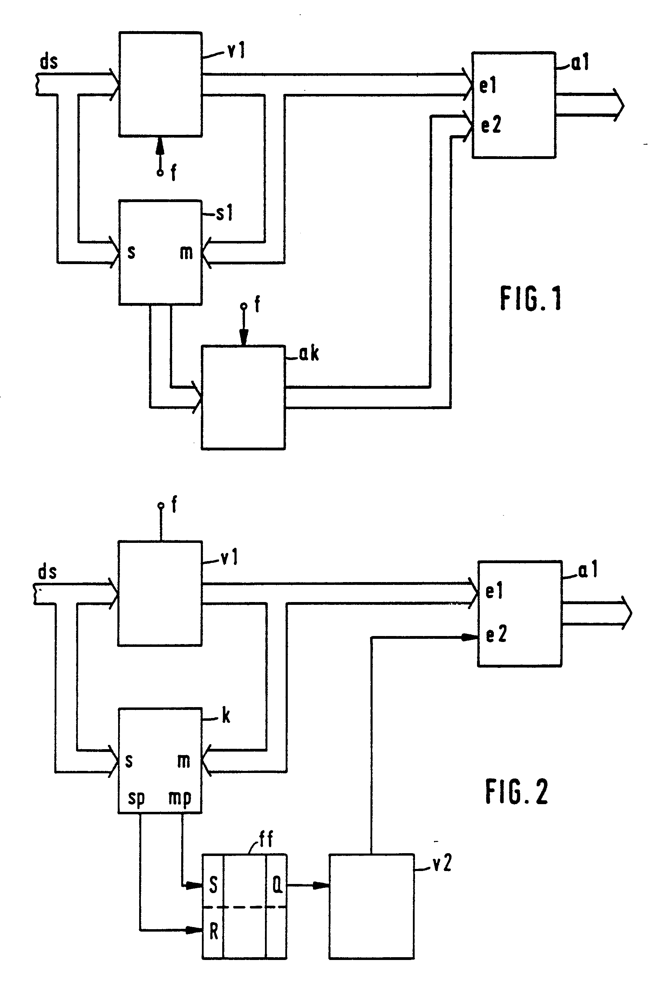

Das Blockschaltbild der Fig. 1 zeigt ein Ausführungsbeispiel der Erfindung. Wie durch die bandförmigen Verbindungsleitungen angedeutet ist, die auch üblicherweise als Bus bezeichnet werden, ist die Digitalschaltung für parallele Signalverarbeitung ausgelegt. Die im folgenden genannten Eingänge und Ausgänge der einzelnen Teilschaltungen sind daher entsprechende Paralleleingänge und -ausgänge. Das Digitalsignal ds ist dem Subtrahend-Eingang s des ersten Subtrahierers s1 und dem Eingang des ersten Verzögerungsglieds v1 zugeführt, dessen Ausgang am ersten Eingang e1 des ersten Addierers a1 und am Minuend-Eingang m des ersten Subtrahierers s1 liegt. Die Verzögerungszeit des ersten Verzögerungsglieds v1 ist gleich der Periodendauer des Taktsignals f. Der Ausgang des ersten Subtrahierers s1 liegt am Eingang des symmetrisch begrenzenden Akkumulators ak, der ebenfalls wie das erste Verzögerungsglied v1 mit dem Taktsignal f gespeist ist. Der Akkumulator ak summiert die am Ausgang des ersten Subtrahierers s1 auftretenden Digitalsignale bis zum oberen bzw. unteren Begrenzungswert auf, wo er bei dessen Erreichen sozusagen stehen bleibt, wenn weitere Eingangssignale desselben Vorzeichens auftreten. Dazu kann er beispielsweise aus einem weiteren Addierer bestehen, der von einem Pufferspeicher oder Register gefolgt ist, dessen Ausgang über einen entsprechenden Begrenzer mit dem anderen Eingang des weiteren Addierers verbunden ist. Zu jedem Taktzeitpunkt des Taktsignals f wird somit zum Digitalsignal im Register ein neuer Signalwert, nämlich der am Ausgang des ersten Subtrahierers s1, hinzuaddiert.

Der Ausgang des Akkumulators ak liegt an den entsprechenden niederwertigen Stellen des zweiten Eingangs e2 des ersten Addierers a1. Der Akkumulierbereich des Akkumulators ak, also der Bereich zwischen dem positiven und dem negativen Begrenzungswert, ist dabei gleich dem Wertebereich der zu unterdrückenden Änderungen des Digitalsignals ds. Das kompensierte Digitalsignal kann am Ausgang des ersten Addierers a1 abgenommen werden.

Die Fig. 2 zeigt eine Abwandlung der Anordnung nach Fig. 1, die dann sinnvoll ist, wenn lediglich Änderungen in der niederstwertigen Stelle des Digitalsignals ds zu kompensieren sind und seine positiven Werte im natürlichen Dualcode und seine negativen Werte in der Zweierkomplementdarstellung des natürlichen Dualcodes vorliegen. Für diesen Fall ist der erste Subtrahierer s1 nach Fig. 1 als Komparator k ausgebildet, dessen Minuend-größer-Subtrahend-Ausgang mp mit dem S-Eingang des RS-Speicherflipflops ff verbunden ist. Der Subtrahend-größer-Minuend-Ausgang sp ist dagegen mit dem entsprechenden R-Eingang verbunden. Der Q-Ausgang (bei positiver Logik ist das der Ausgang, der beim positiveren Pegel H zweier Binärpegel H, L am S-Eingang ebenfalls einen H-Pegel führt), der Q-Ausgang liegt also am Eingang des mit dem ersten Verzögerungsglied v1 identischen Verzögerungsglieds v2, dessen Ausgang mit allen Stellen des zweiten Eingangs e2 des ersten Addierers a1 verbunden ist.

Im Betrieb wird durch das erste Verzögerungsglied v1 das Digitalsignal ds um eine Taktperiode des Taktsignals f verzögert, so daß mittels des ersten Subtrahierers s1 aus diesen beiden Signalen die

2

Differenz gebildet werden kann. Diese wird mittels des Akkumulators ak aufsummiert, und der akkumulierte Wert wird ggf auf den positiven bzw. negativen Grenzwert begrenzt. Das Ausgangssignal des Akkumulators ak wird dann mittels des ersten Addierers a1 vorzeichenrichtig zum Digitalsignal am Ausgang des ersten Verzögerungsglieds v1 addiert. Somit werden Änderungen des Digitalsignals ds, die auf Störungen beruhen, unterdrückt.

Bei der Anordnung nach Fig. 2 wird ebenfalls das funktionelle Grundprinzip nach Fig. 1 angewendet, jedoch kann für den Spezialfall der Fig. 2 von der Eigenschaft der Codierung positiver und negativer Zahlen mittels des natürlichen Dualcodes und dessen Zweierkomplementdarstellung Gebrauch gemacht werden, daß nämlich die Dezimalzahl — 1 als Digitalsignal mit lauter Einsen auftritt. Wenn also der Ausgang des zweiten Verzögerungsglieds v1 mit allen Stellen des zweiten Eingangs e2 des ersten Addierers a1 in Fig. 2 verbunden ist, so wird bei einer Eins am Ausgang des zweiten Verzögerungsglieds v2 mittels des ersten Addierers a1 die Summe aus dem verzögerten Digitalsignal ds und — 1 gebildet, dagegen bei einer Null am Ausgang des zweiten Verzögerungsglieds v2 das verzögerte Digitalsignal ds unverändert gelassen.

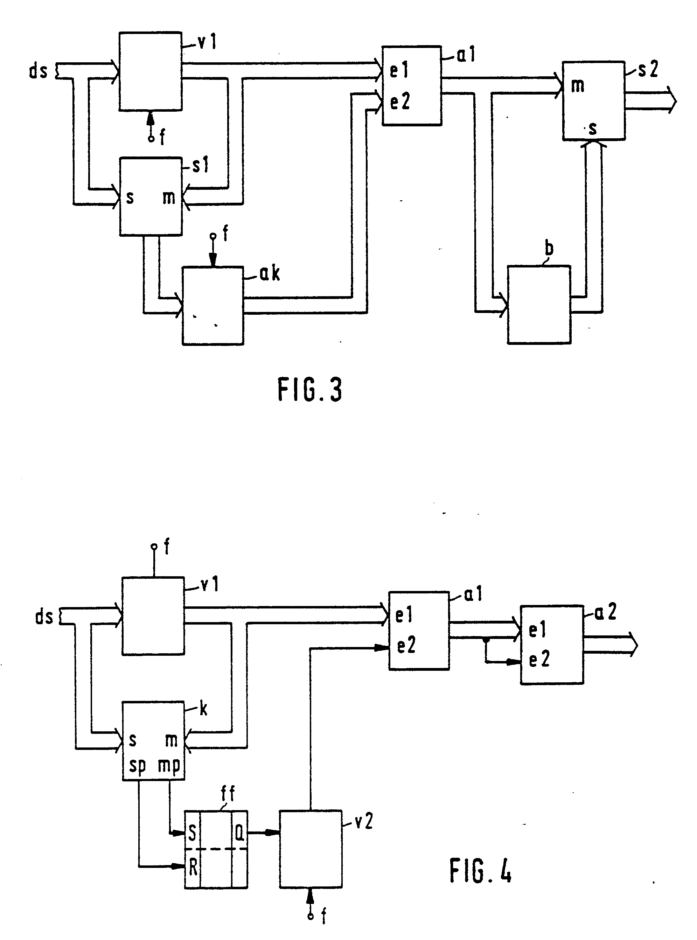

In Fig. 3 ist eine Weiterbildung der Anordnung nach Fig. 1 gezeigt. Damit kann das Verhalten der Schaltung nach Fig. 1 ausgeglichen werden, am Ausgang des ersten Addierers a1 von der Änderungsrichtung im Digitalsignal ds abhängige Ausgangssignale zu liefern. Das bedeutet, daß die Kompensierung einer negativ gerichteten Änderung ein anderes Ausgangssignal ergibt als die Kompensierung einer positiv gerichteten Änderung.

Die Weiterbildung der Fig. 3 enthält zusätzlich zu den mit der Anordnung nach Fig. 1 identischen Stufen den Begrenzer b, der am Ausgang des ersten Addierers a1 liegt, und den zweiten Subtrahierer s2, dessen Minuend-Eingang m ebenfalls am Ausgang des ersten Addierers a1 und dessen Subtrahend-Eingang s am Ausgang des Begrenzers b liegt. Der Begrenzer b hat einen Durchlaßbereich, der dem Wertebereich der zu unterdrückenden Änderungen des Digitalsignals ds entspricht.

Die Fig. 4 zeigt die der Fig. 3 entsprechende Weiterbildung für die Abwandlung nach Fig. 2. In diesem Falle kann auf den Begrenzer b nach Fig. 3 verzichtet werden, weil auf die Eigenschaften der Codierung im natürlichen Binärcode und dessen Zweierkomplement für negative Zahlen dahingehend zurückgegriffen werden kann, daß anstatt des zweiten Subtrahierers s2 nach Fig. 3 der zweite Addierer a2 nach Fig. 4 vorgesehen wird und die niederstwertige Stelle von dessen zweitem Eingang e2 mit der Vorzeichenstelle des Ausgangssignals des ersten Addierers a1 verbunden ist. Da bei der erwähnten Codierung das negative Vorzeichen einer Eins in dieser Vorzeichenstelle entspricht, wird somit zu einem negativen Signal am ersten Eingang e1 des zweiten Addierers a2 eine + 1 addiert, und somit der negative Wertebereich um eins in positive Richtung verschoben.

Zur Veranschaulichung der Wirkungsweise der Digitalschaltung nach der Erfindung dient die Tabelle, in der sowohl das statische als auch das dynamische Verhalten der Schaltung durch Angabe entsprechender dezimaler Zahlenwerte angegeben ist. Bei den statischen Werten ist in der zweiten und dritten Spalte durch « oder » angegeben, daß diese Ausgangswerte von der Änderungsrichtung des Digitalsignals ds abhängen. Hervorzuheben ist, daß beim Wert ds = 0 zwei Werte am Ausgang des ersten Addierers a1, dagegen nur noch ein Wert am Ausgang des Addierers a2 auftreten, was auf dessen oben geschilderte Funktion zurückzuführen ist. Im dynamischen Fall trifft dies auf die mittleren drei Werte der Tabelle zu.

Bei den dynamischen Angaben bedeutet der Schrägstrich, daß zwischen den ihm zugeordneten beiden Werten ein Hin- und Herspringen (Jittern) stattfindet.

Tabelle

| | ds | Ausgang von a1 | Ausgang von a2 |
|---|---|---|---|
| **statisch** | + 2 | + 1 oder + 2 | + 1 oder + 2 |
| | + 1 | 0 oder + 1 | 0 oder + 1 |
| | 0 | 0 oder − 1 | 0 |
| | − 1 | − 1 oder − 2 | 0 oder − 1 |
| | − 2 | − 2 oder − 3 | − 1 oder − 2 |
| **dynamisch** | + 5 / + 6 | + 5 | + 5 |
| | + 2 / 0 | + 1 / 0 | + 1 / 0 |
| | + 1 / 0 | 0 | 0 |
| | + 1 / − 1 | 0 / − 1 | 0 |
| | − 1 / 0 | − 1 | 0 |
| | − 2 / 0 | − 2 / − 1 | − 1 / 0 |
| | − 5 / − 6 | − 6 | − 5 |

Die Digitalschaltung nach der Erfindung läßt sich vorteilhaft als integrierte Schaltung realisieren. Dabei kann sie aufgrund ihres geringen schaltungstechnischen Umfangs als Teilschaltung einer umfangreichen integrierten Schaltung eingesetzt werden. Eine bevorzugte Anwendung besteht in Farbfernsehgeräten mit digitaler Signalverarbeitung nach der Offenlegungsschrift DE 28 54 236 A1 zur Unterdrückung von in Digitalsignalen auftretendem Rauschen.

**Patentansprüche**

1. Digitalschaltung zur getakteten Unterdrückung von Digitalsignal-Änderungen, deren Vorzeichen umgekehrt zum Vorzeichen von Digitalsignal-Änderungen vorausgegangener Zeitpunkte eines Taktsignals (f) ist, wobei die positiven Werte des Digitalsignals (ds) im natürlichen Dualcode und seine negativen Werte in der Zweierkomplementdarstellung des natürlichen Dualcodes vorliegen, gekennzeichnet durch folgende Merkmale :
— die Digitalschaltung ist für parallele Signalverarbeitung ausgelegt,
— das Digitalsignal (ds) ist einem ersten Verzögerungsglied (v1), dessen Verzögerungszeit gleich der Periodendauer des Taktsignals (f) ist, und dem Subtrahend-Eingang (s) eines ersten Subtrahierers (s1) zugeführt,
— der Ausgang des ersten Verzögerungsglieds (v1) liegt am Minuend-Eingang (m) des ersten Subtrahierers (s1) und am ersten Eingang (e1) eines ersten Addierers (a1),
— der Ausgang des ersten Subtrahierers (s1) liegt am Eingang eines vom Taktsignal (f) getakteten symmetrisch begrenzenden Akkumulators (ak), dessen Ausgang mit den entsprechenden niederwertigen Stellen des zweiten Eingangs (e2) des ersten Addierers (a1) verbunden ist, und
— der Akkumulierbereich des Akkumulators (ak) ist gleich dem Wertebereich der zu unterdrückenden Änderungen.
2. Digitalschaltung nach Anspruch 1, dadurch gekennzeichnet, daß der Ausgang des ersten Addierers (a1) am Minuend-Eingang (m) eines zweiten Subtrahiers (s2) und am Eingang eines Begrenzers (b) liegt, dessen Ausgang mit den entsprechenden niederwertigen Stellen des zweiten Eingangs (e2) des zweiten Subtrahierers (s2) verbunden ist und dessen Durchlaßbereich gleich dem Wertebereich der zu unterdrückenden Änderungen ist.
3. Digitalschaltung nach Anspruch 1 zur Unterdrückung von Änderungen in der niederstwertigen Stelle eines Digitalsignals (ds), dessen positive Werte im natürlichen Dualcode und dessen negative Werte in der Zweierkomplement-Darstellung des natürlichen Dualcodes auftreten, gekennzeichnet durch folgende Merkmale :
— der erste Subtrahierer (s1) ist als Komparator (k) ausgebildet, dessen Minuend-größer-Subtrahend-Ausgang (mp) am S-Eingang eines RS-Speicherflipflops (ff) und dessen Substrahend-größer-Minuend-Ausgang (sp) an dessen R-Eingang liegt, und
— der Q-Ausgang des RS-Speicherflipflops (ff) liegt am Eingang eines zweiten, zum ersten identischen Verzögerungsglieds (v2), dessen Ausgang mit allen Stellen des zweiten Eingangs (e2) des ersten Addierers (a1) verbunden ist.
4. Digitalschaltung nach Anspruch 3, dadurch gekennzeichnet, daß der Ausgang des ersten Addierers (a1) mit dem ersten Eingang (e1) eines zweiten Addierers (a2) verbunden ist und daß die Vorzeichenstelle des Ausgangssignals des ersten Addierers (a1) an der niederstwertigen Stelle des zweiten Eingangs (e2) des zweiten Addierers liegt.
5. Verwendung der Digitalschaltung nach einem der Ansprüche 1 bis 4 in Farbfernsehgeräten mit digitaler Signalverarbeitung zur Unterdrückung von in Digitalsignalen auftretendem Rauschen.

**Claims**

1. Digital circuit for the clocked suppression of changes in a multidigit, the sign of which is opposite to the sign of signal changes at previous instants of a clock signal (f), the positive values of the digital signal (ds) existing in the natural dual code and its negative values in the two's complement of the natural dual code, signal which have signs opposite to those of signal changes at previous instants of a clock signal (f), characterized by the following features :
— The digital circuit is designed for parallel signal processing ;
— the digital signal (ds) is applied to a first delay element (v1) providing a delay equal to the period of the clock signal (f), and to the subtrahend input (s) of a first subtracter (s1) ;
— the output of the first delay element (v1) is connected to the minuend input (m) of the first subtracter (s1) and to the first input (e1) of a first adder (a1) ;
— the output of the first subtracter (s1) is connected to the input of a symmetrically limiting accumulator (ak) which is clocked by the clock signal (s) and has its output connected to the corresponding low-order terminals of the second input (e2) of the first adder (a1), and
— the range of accumulation of the accumulator (ak) is equal to the range of values of the changes to be suppressed.

4

2. A digital circuit as claimed in claim 1, characterized in that the output of the first adder (a1) is connected to the minuend input (m) of a second subtracter (s2) and to the input of a limiter (b) whose output is connected to the corresponding low-order terminals of the second input (e2) of the second subtracter (s2), and whose pass range is equal to the range of values of the changes to be suppressed.

3. A digital circuit as claimed in claim 1 for suppressing changes in the least significant bit of a digital signal (ds) whose positive and negative values occur in the binary code and the binary two's complement, respectively, characterized by the following features :

— The first subtracter (s1) is designed as a comparator (k) whose minuend-greater-than-subtrahend output (mp) is connected to the S input of an RS flip-flop (ff), and whose subtrahend-greater-than minuend output (sp) is connected to the R input of the RS flip-flop (ff), and

— the Q output of the RS flip-flop (ff) is connected to the input of a second delay element (v2) which is of the same design as the first and has its output connected to all terminals of the second input (e2) of the first adder (a1).

4. A digital circuit as claimed in claim 3, characterized in that the output of the first adder (a1) is connected to the first input (e1) of a second adder (a2), and that the sign-digit terminal of the output of the first adder (a1) is connected to the least significant terminal of the second input (e2) of the second adder.

5. Use of a digital circuit as claimed in any one of claims 1 to 4 in color-television sets with digital signal processing circuitry.

## Revendications

1. Circuit numérique pour la suppression synchrone de variations d'un signal numérique, dont les signes sont opposés aux signes des variations du signal numérique en des périodes précédentes d'un signal de synchronisation (f), les valeurs positives du signal numérique (ds) étant exprimées en code binaire naturel et des valeurs négatives en représentation par complément à deux du code binaire naturel, caractérisé en ce que :

— le circuit numérique est conçu pour un traitement du signal en parallèle,

— le signal numérique (ds) est appliqué à un premier dispositif à retard (v1) dont le temps de retard est égal à la durée d'une période du signal de synchronisation (f) et à l'entrée de terme à soustraire (s) d'un premier soustracteur (s1),

— la sortie du premier dispositif à retard (v1) est connectée à l'entrée de terme principal (m) du premier soustracteur (s1) et à la première entrée (e1) d'un premier additionneur (a1),

— la sortie du premier soustracteur (s1) est connectée à l'entrée d'un accumulateur (ak) à limitation symétrique synchronisé par le signal de synchronisation (f), dont la sortie est connectée aux accès d'ordres inférieurs correspondants de la deuxième entrée (e2) du premier additionneur (a1), et

— la plage d'accumulation de l'accumulateur (ak) est égale à la plage de valeurs des variations à supprimer.

2. Circuit numérique selon la revendication 1, caractérisé en ce que la sortie du premier additionneur (a1) est connectée à l'entrée de terme principal (m) d'un deuxième soustracteur (s2) et à l'entrée d'un limiteur (b) dont la sortie est connectée aux accès d'ordres inférieurs correspondants de la deuxième entrée (e2) du deuxième soustracteur (s2) et dont la plage passante est égale à la plage de valeurs des variations à supprimer.

3. Circuit numérique selon la revendication 1, pour la suppression de variations du chiffre d'ordre inférieur d'un signal numérique (ds) dont les valeurs positives sont exprimées en code binaire naturel et des valeurs négatives en représentation par complément à deux du code binaire naturel, caractérisé en ce que :

— le premier soustracteur (s1) est conçu comme un comparateur (k) dont la sortie « terme principal plus grand que terme à soustraire » (mp) est connectée à l'entrée S d'une bascule RS (ff) et dont la sortie « terme à soustraire plus grand que terme principal » est connectée à l'entrée R de celle-ci, et

— la sortie Q de la bascule RS (ff) est connectée à l'entrée d'un deuxième dispositif de retard (v2) qui est de même conception que le premier et dont la sortie est connectée à tous les accès de la deuxième entrée (e2) du premier additionneur (a1).

4. Circuit numérique selon la revendication 3, caractérisé en ce que la sortie du premier additionneur (a1) est connectée à la première entrée (e1) d'un deuxième additionneur (a2), et en ce que l'accès de signe de la sortie du premier additionneur (a1) est connecté à l'accès d'ordre inférieur de la deuxième entrée (e2) du deuxième additionneur.

5. Application du circuit numérique selon l'une quelconque des revendications 1 à 4 dans les postes de télévision couleurs avec traitement numérique du signal, pour la suppression du bruit d'un signal numérique.

FIG.1

FIG.2

FIG.3

FIG.4